# EUROPEAN PATENT APPLICATION

(11) **EP 4 779 237 A1**
(43) Date of publication of application: **22.07.2026**
(21) Application number: 26151502.7
(22) Date of filing: 13.01.2026
(51) Int. Cl.: F25B 25/00, F25B 41/22, F25B 49/02, H05K 7/20

(54) **COOLING SYSTEM**

(30) Priority: 15.01.2025 US 202563745657 P; 02.01.2026 US 202619439253
(71) Applicant: Vertiv Corporation, Westerville, OH 43082 (US)
(72) Inventor: GERIG, Galen Lewis, WESTERVILLE (US); BREUER, Thomas Christopher, WESTERVILLE (US); RAVEN, Matthew Alan, WESTERVILLE (US); BLASER, Colin Lewis, WESTERVILLE (US); MILLER, Oliver McKenzey, WESTERVILLE (US)
(74) Representative: Beal, James Michael

(57) **Abstract**

A cooling system can include a primary cooling loop having a primary cooling fluid, a secondary cooling loop having a secondary cooling fluid, a heat exchanger for transferring heat to the primary cooling fluid from the secondary cooling fluid, and a controller. The heat exchanger can be a brazed plate heat exchanger arranged for providing a low supply temperature of the secondary cooling fluid supplied to a load. The system can increase the supply temperature by injecting hot secondary cooling fluid upstream of the load, such as by using a bypass valve in the secondary cooling loop.

## Description

### CROSS-REFERENCE TO RELATED APPLICATION(S)

This application claims the benefit of priority of U.S. Provisional Patent Application No. 63/745,657 filed January 15, 2025 and U.S. Non-provisional Patent Application No. 19/439,253 filed January 2, 2026.

### TECHNICAL FIELD

The present disclosure relates generally to cooling systems and more specifically relates to cascaded cooling systems.

### BACKGROUND

Cooling systems, such as cascaded cooling systems and other cooling systems used in data centers, often use a brazed plate heat exchanger (BPHE) to transfer heat from one cooling loop to another. Generally, a BPHE can only efficiently operate within a particular range of conditions to provide a desired supply temperature to a load. If a given fluid supply temperature is too low for a given BPHE, the refrigerant suction pressure may decrease, which can cause freezing. If a given fluid supply temperature is too high for a given BPHE, the refrigerant suction pressure may increase, which can also cause serious problems for the compressor. These and other issues typically require the BPHE to be specifically sized for each application, which can result in increased design time and costs, as well as other inefficiencies.

### SUMMARY

Applicant has created new and useful devices, systems and methods for cooling systems, such as cascaded cooling systems. In at least one embodiment, a cooling system according to the disclosure can accommodate a wide range of conditions and/or supply temperatures utilizing a brazed plate heat exchanger (BPHE) of a single size. In at least one embodiment, a cooling system according to the disclosure can utilize a BPHE large enough to provide a supply temperature as low as 50 degrees Fahrenheit, while still being able to provide a supply temperature as high as 115 degrees Fahrenheit (or anywhere in between), by selectively bypassing the BPHE with at least a portion of secondary cooling fluid and injecting relatively warm secondary cooling fluid upstream of the load.

In at least one embodiment, a cooling system according to the disclosure can include one or more primary cooling loops having a primary cooling fluid circulating therein, one or more secondary cooling loops having a secondary cooling fluid circulating therein, one or more heat exchangers for transferring heat to the primary cooling fluid from the secondary cooling fluid, or any combination thereof. In at least one embodiment, the heat exchanger can be plumbed fluidically in line with the primary cooling loop and/or the secondary cooling loop. In at least one embodiment, the heat exchanger can be a brazed plate heat exchanger and/or another type of fluid-to-fluid heat exchanger. In at least one embodiment, the heat exchanger can be sized or otherwise arranged to provide a supply temperature of the secondary cooling fluid supplied to a load as low as 50 degrees Fahrenheit. In at least one embodiment, the heat exchanger can be sized or otherwise arranged to provide a supply temperature of the secondary cooling fluid supplied to the load at any temperature from 50 degrees Fahrenheit to 115 degrees Fahrenheit.

In at least one embodiment, the primary cooling fluid can be a two-phase fluid, such as a refrigerant. In at least one embodiment, the primary cooling loop can include one or more compressors for circulating the primary cooling fluid through the primary cooling loop and/or compressing at least a portion of the primary cooling fluid, such as that portion vaporized in the heat exchanger, one or more condensers for condensing at least a portion of the primary cooling fluid and/or rejecting heat to an environment, or any combination thereof.

In at least one embodiment, the secondary cooling fluid can be a single-phase cooling fluid, such as a water-glycol mixture. In at least one embodiment, the secondary cooling loop can include one or more prime movers, such as a pump, for circulating the secondary cooling fluid through the secondary cooling loop, one or more loads for transferring heat to the secondary cooling fluid, one or more bypass valves plumbed in parallel with the heat exchanger for selectively permitting a bypass portion of the secondary cooling fluid to bypass the heat exchanger, or any combination thereof. In at least one embodiment, the bypass valve can be an electronically controlled valve. In at least one embodiment, the bypass portion of the secondary cooling fluid can flow from the load through the bypass valve, then through the prime mover, and then through the load. In at least one embodiment, a remaining portion of the secondary cooling fluid can flow from the load through the heat exchanger, then through the prime mover, and then through the load.

In at least one embodiment, a cooling system according to the disclosure can include one or more controllers for monitoring various aspects of the system and/or controlling various components of the system, such as the bypass valve. In at least one embodiment, the controller can monitor a suction pressure at the compressor, such as via a pressure transducer and/or other sensor. In at least one embodiment, the controller can control the suction pressure at the compressor using the bypass valve.

In at least one embodiment, the controller can control the bypass valve according to the suction pressure at the compressor, such as using a proportional-integral-derivative (PID) feedback control loop (or any component thereof) and/or a deadband (such as to limit movement of the bypass valve). In at least one embodiment, the controller can increase flow through the bypass valve as the suction pressure at the compressor increases and/or increase flow through the bypass valve when the suction pressure at the compressor increases a predetermined amount. In at least one embodiment, the controller can decrease flow through the bypass valve as the suction pressure at the compressor decreases and/or decrease flow through the bypass valve when the suction pressure at the compressor decreases a predetermined amount.

In at least one embodiment, the controller can monitor a supply temperature of the secondary cooling fluid supplied to the load. In at least one embodiment, the controller can control the supply temperature using the bypass valve. In at least one embodiment, the controller can control the supply temperature at any temperature from 50 degrees Fahrenheit to 115 degrees Fahrenheit. In at least one embodiment, the heat exchanger and/or other components of the system can be sized and/or otherwise arranged to provide a supply temperature of the secondary cooling fluid supplied to the load as low as 50 degrees Fahrenheit and the controller can control the supply temperature, such as using the bypass valve, to as high as 115 degrees Fahrenheit. In at least one embodiment, the controller can selectively increase a supply temperature of the secondary cooling fluid supplied to the load and/or otherwise control the suction pressure at the compressor by selectively extracting hot secondary cooling fluid upstream of the heat exchanger and/or injecting hot secondary cooling fluid between the heat exchanger and the load, such as downstream of the heat exchanger and upstream of the load.

### BRIEF DESCRIPTION OF THE DRAWINGS

FIG. 1 is a schematic of one of many embodiments of a primary cooling loop of a cooling system according to the disclosure.
FIG. 2 is a schematic of one of many embodiments of a secondary cooling loop of a cooling system according to the disclosure.
FIG. 3 is a schematic of another one of many embodiments of a secondary cooling loop of a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for cooling systems, such as cascaded cooling systems. In at least one embodiment, a cooling system according to the disclosure can accommodate a wide range of conditions and/or supply temperatures utilizing a brazed plate heat exchanger (BPHE) of a single size. In at least one embodiment, a cooling system according to the disclosure can utilize a BPHE large enough to provide a supply temperature as low as 50 degrees Fahrenheit, while still being able to provide a supply temperature as high as 115 degrees Fahrenheit (or anywhere in between), by selectively bypassing the BPHE with at least a portion of secondary cooling fluid and injecting relatively warm secondary cooling fluid upstream of the load.

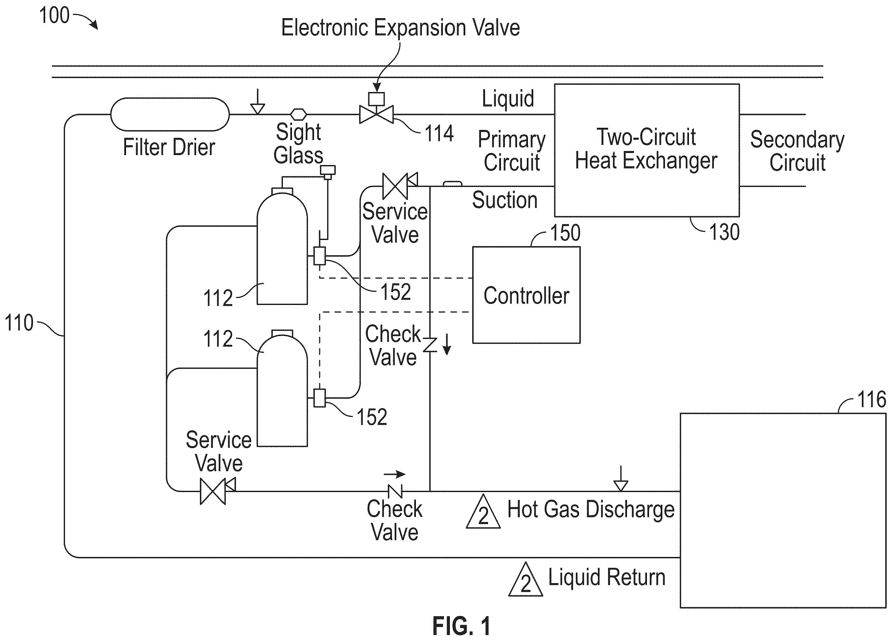

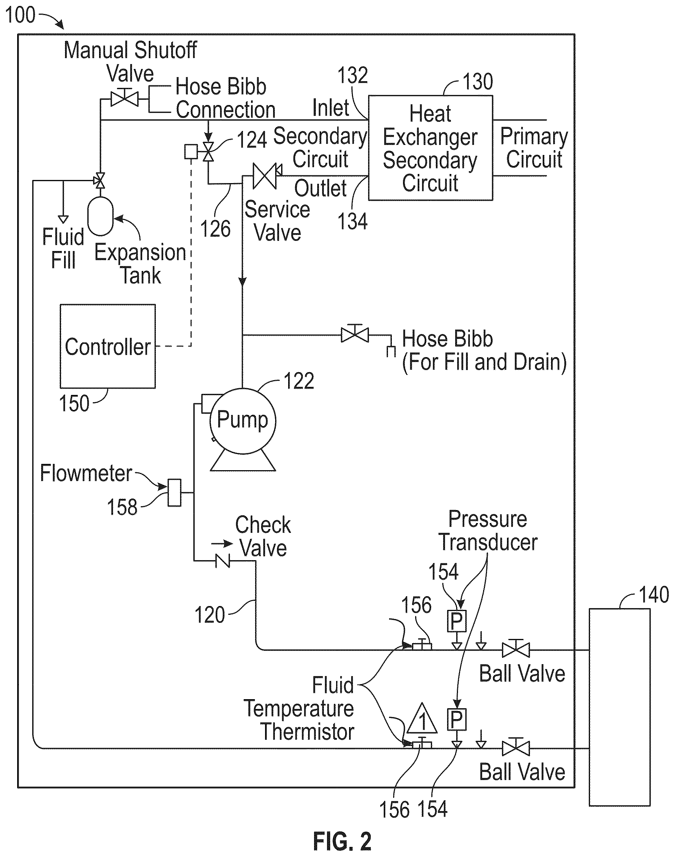

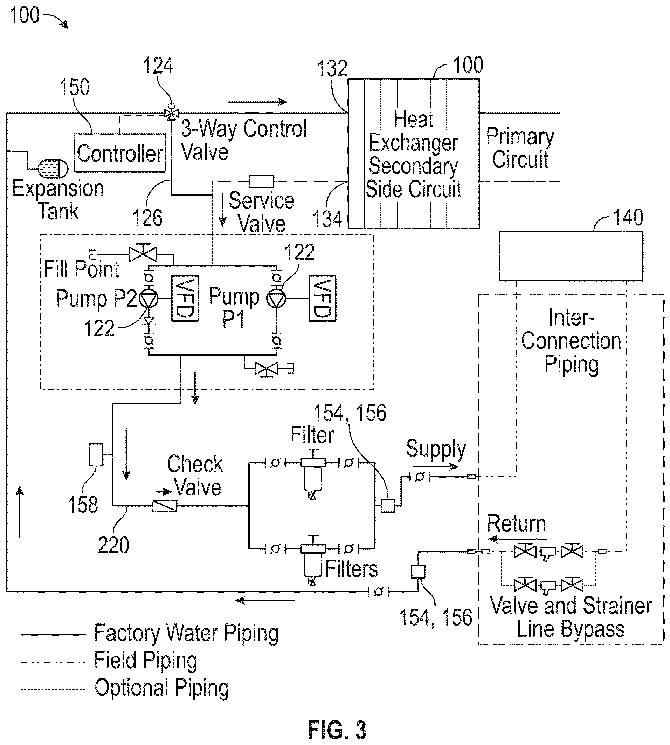

FIG. 1 is a schematic of one of many embodiments of a primary cooling loop of a cooling system according to the disclosure. FIG. 2 is a schematic of one of many embodiments of a secondary cooling loop of a cooling system according to the disclosure. FIG. 3 is a schematic of another one of many embodiments of a secondary cooling loop of a cooling system according to the disclosure. FIGS. 1-3 are described in conjunction with one another.

In at least one embodiment, a cooling system 100 according to the disclosure, such as a cascaded cooling system, can include one or more primary cooling loops 110 for circulating a primary cooling fluid, one or more secondary cooling loops 120, 220 for circulating a secondary cooling fluid, one or more heat exchangers 130 for transferring heat to the primary cooling fluid from the secondary cooling fluid, or any combination thereof. In at least one embodiment, the heat exchanger 130 can be plumbed fluidically in line with the primary cooling loop 110 and/or the secondary cooling loop 120, 220. In at least one embodiment, the heat exchanger 130 can be a brazed plate heat exchanger (BPHE) and/or another type of fluid-to-fluid heat exchanger.

In at least one embodiment, the heat exchanger 130 can be sized or otherwise arranged to provide a lowest anticipated supply temperature of the secondary cooling fluid supplied to one or more loads 140 in accordance with a given implementation of the disclosure. For example, in at least one embodiment, the heat exchanger 130 can be sized or otherwise arranged to provide a supply temperature of the secondary cooling fluid supplied to the load 140 as low as 40 degrees Fahrenheit. As another example, in at least one embodiment, the heat exchanger 130 can be sized or otherwise arranged to provide a supply temperature of the secondary cooling fluid supplied to the load 140 as low as 50 degrees Fahrenheit. In at least one embodiment, the heat exchanger 130 and/or one or more other components of the system 100 can be sized or otherwise arranged to provide a supply temperature of the secondary cooling fluid supplied to the load 140 at any temperature from 40 degrees Fahrenheit to 130 degrees Fahrenheit. In at least one embodiment, the heat exchanger 130 and/or one or more other components of the system 100 can be sized or otherwise arranged to provide a supply temperature of the secondary cooling fluid supplied to the load 140 at any temperature from 50 degrees Fahrenheit to 115 degrees Fahrenheit.

In at least one embodiment, the primary cooling fluid can be a two-phase fluid, such as a refrigerant. In at least one embodiment, the primary cooling loop 110 can include one or more compressors 112 for circulating the primary cooling fluid through the primary cooling loop 110 and/or compressing at least a portion of the primary cooling fluid, such as a portion vaporized in the heat exchanger 130, one or more expansion valves 114 for controlling vaporization of the primary cooling fluid in the heat exchanger 130, one or more condensers 116 for condensing at least a portion of the primary cooling fluid and/or rejecting heat to an environment, or any combination thereof.

In at least one embodiment, the secondary cooling fluid can be a single-phase cooling fluid, such as water or a water-glycol mixture. In at least one embodiment, the secondary cooling loop 120, 220 can include one or more prime movers 122, such one or more pumps, for circulating the secondary cooling fluid through the secondary cooling loop 120, 220, one or more loads 140, such as direct-to-chip and/or other heat exchangers, for transferring heat to the secondary cooling fluid, such as from computing equipment or other information technology (IT) equipment, one or more bypass valves (or mixing valves) 124 plumbed in parallel with the heat exchanger 130 for selectively permitting a bypass portion of the secondary cooling fluid to bypass the heat exchanger 130, or any combination thereof.

In at least one embodiment, the bypass valve 124 can be an electronically controlled valve, such as an electrically or pneumatically actuated valve. In at least one embodiment, the bypass valve 124 can be a two-way valve and, for example, can be disposed in a bypass line 126 having one end plumbed upstream of an inlet 132 of the heat exchanger 130 and another end plumbed downstream of an outlet 134 of the heat exchanger 130 (see, e.g., FIG. 2). In at least one embodiment, the bypass valve 124 can be a three-way valve and, for example, can be disposed upstream of an inlet 132 of the heat exchanger 130, with the bypass line 126 having one end coupled to an outlet of the bypass valve 124 and another end plumbed downstream of an outlet 134 of the heat exchanger 130 (see, e.g., FIG. 3).

In at least one embodiment, the bypass portion of the secondary cooling fluid can flow from the load 140 through the bypass valve 124, then through the prime mover 122, and then through the load 140, in that order. In at least one embodiment, a remaining portion of the secondary cooling fluid can flow from the load 140 through the heat exchanger 130, then through the prime mover 122, and then through the load 140, in that order. In at least one embodiment, the remaining portion of the secondary cooling fluid can be cooled in the heat exchanger 130, such as to 50 degrees Fahrenheit (or another applicable temperature), while the bypass portion of the secondary cooling fluid can retain heat from the load 140. In at least one embodiment, the bypass portion of the secondary cooling fluid, which can remain hot by bypassing the heat exchanger 130, can be combined with the remaining portion of the secondary cooling fluid, which can be cooled in the heat exchanger 130, to provide a supply temperature of the secondary cooling fluid supplied to the load 140 at any temperature from 40 or 50 degrees Fahrenheit to 115 or 130 degrees Fahrenheit.

In at least one embodiment, a cascaded cooling system 100 according to the disclosure can include one or more controllers 150 for monitoring one or more aspects of the system 100 and/or controlling one or more components of the system 100. In at least one embodiment, the controller 150 can monitor one or more pressures, one or more temperatures, one or more flow rates, or any combination thereof. In at least one embodiment, the controller 150 can monitor one or more sensors, such as one or more pressure transducers or other pressure sensors, one or more temperature thermistors or other temperature sensors, one or more flow meters or other flow rate sensors, or any combination thereof.

In at least one embodiment, the controller 150 can control one or more pressures, one or more temperatures, one or more flow rates, or any combination thereof, such as by controlling the compressor 112, the expansion valve 114, the prime mover 122, the bypass valve 124, other valves, other components of, or otherwise associated with, the system 100, or any combination thereof. In at least one embodiment, the controller 150 can monitor a suction pressure at one or more compressors 112, such as via one or more pressure sensors 152. In at least one embodiment, the controller 150 can control the suction pressure at the compressor 112 using the bypass valve 124, such as by controlling a position of the bypass valve 124.

In at least one embodiment, the controller 150 can control the bypass valve 124 according to the suction pressure at the compressor 112, such as using a proportional-integral-derivative (PID) feedback control loop (or any component thereof) and/or a deadband (such as to limit movement of the bypass valve 124). In at least one embodiment, the controller 150 can increase flow through the bypass valve 124 as the suction pressure at the compressor 112 increases and/or can increase flow through the bypass valve 124 when the suction pressure at the compressor 112 increases a predetermined amount. In at least one embodiment, the controller 150 can decrease flow through the bypass valve 124 as the suction pressure at the compressor 112 decreases and/or can decrease flow through the bypass valve 124 when the suction pressure at the compressor 112 decreases a predetermined amount. Such predetermined amounts can be any amount(s) required or desired in accordance with a given implementation of the disclosure.

In at least one embodiment, the controller 150 can control the supply temperature by controlling a proportion of the bypass portion of the secondary cooling fluid versus the remaining portion of the secondary cooling fluid. In at least one embodiment, increasing flow through the bypass valve 124 can increase the supply temperature by increasing the bypass portion of the secondary cooling fluid that bypasses the heat exchanger 130 and/or decreasing the remaining portion of the secondary cooling fluid that is cooled in the heat exchanger 130. In at least one embodiment, decreasing flow through the bypass valve 124 can decrease the supply temperature by decreasing the bypass portion of the secondary cooling fluid that bypasses the heat exchanger 130 and/or increasing the remaining portion of the secondary cooling fluid that is cooled in the heat exchanger 130.

In at least one embodiment, the controller 150 can increase flow through the bypass valve 124 by further opening the bypass valve 124 and/or increasing a speed of the prime mover 122. In at least one embodiment, the controller 150 can decrease flow through the bypass valve 124 by further closing or restricting flow through the bypass valve 124 and/or decreasing the speed of the prime mover 122. In at least one embodiment, the controller 150 can monitor a flow rate of the secondary cooling fluid, such as via a flowmeter 158 disposed downstream of the prime mover 122. In at least one embodiment, the controller 150 can prevent excessive operation, or limit actuation/movement, of the bypass valve 124 by opening and/or closing the bypass valve 124 when the suction pressure changes by the predetermined amount(s), which can be the same or different, or by utilizing another deadband control scheme.

In at least one embodiment, the controller 150 can monitor a supply pressure of the secondary cooling fluid supplied to the load 140 and/or a return pressure of the secondary cooling fluid leaving the load 140, such as via one or more pressure sensors 154. In at least one embodiment, the controller 150 can monitor a supply temperature of the secondary cooling fluid supplied to the load 140 and/or a return temperature of the secondary cooling fluid leaving the load 140, such as via one or more temperature sensors 156. In at least one embodiment, the controller 150 can control the supply temperature using the bypass valve 124. In at least one embodiment, the controller 150 can control or maintain the supply temperature at any temperature from 40 degrees Fahrenheit to 130 degrees Fahrenheit. In at least one embodiment, the controller 150 can control or maintain the supply temperature at any temperature from 50 degrees Fahrenheit to 115 degrees Fahrenheit.

In at least one embodiment, the heat exchanger 130 and/or one or more other components of the system 100 can be sized and/or otherwise arranged for providing a low supply temperature of the secondary cooling fluid supplied to the load 140, e.g., as low as 40 or 50 degrees Fahrenheit, and the controller 150 can control the supply temperature, such as using the bypass valve 124 and/or otherwise mixing hot secondary cooling fluid bypassing the heat exchanger 130 with cold secondary cooling fluid cooled in the heat exchanger 130, to obtain a hotter supply temperature as high as 115 or 130 degrees Fahrenheit. In at least one embodiment, the controller 150 can selectively increase a supply temperature of the secondary cooling fluid supplied to the load 140 and/or can otherwise control the suction pressure at the compressor 112 by selectively extracting hot secondary cooling fluid upstream of the heat exchanger 130 and/or injecting hot secondary cooling fluid between the heat exchanger 130 and the load 140, such as downstream of the heat exchanger 130 and upstream of the load 140.

As will be appreciated by a person of ordinary skill in the art having the benefits of the present disclosure, any or all of the cooling loops or circuits of a cooling system according to the disclosure can include any of various components (in any number) for supporting fluid flow and/or cooling operations in accordance with a given implementation of the disclosure, such as, but not limited to, pipes and/or other fluid conduits, fittings, filter driers, sight glasses, service valves, check valves, fluid fill connections, fluid drain connections, hose bibs, shutoff valves, expansion tanks, control valves, on/off valves, strainers, filters, other cooling system components, or any combination thereof.

As will be appreciated by those skilled in the art having the benefits of the present disclosure, aspects of one or more embodiments of the disclosure can be embodied as a system, method or computer program product. Accordingly, aspects of the present embodiments can take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to embodiments of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one embodiment, a cooling system according to the disclosure can include one or more primary cooling loops having a primary cooling fluid circulating therein, one or more secondary cooling loops having a secondary cooling fluid circulating therein, one or more heat exchangers for transferring heat to the primary cooling fluid from the secondary cooling fluid, or any combination thereof. In at least one embodiment, the heat exchanger can be plumbed fluidically in line with the primary cooling loop and/or the secondary cooling loop. In at least one embodiment, the heat exchanger can be a brazed plate heat exchanger and/or another type of fluid-to-fluid heat exchanger. In at least one embodiment, the heat exchanger can be sized or otherwise arranged to provide a supply temperature of the secondary cooling fluid supplied to a load as low as 50 degrees Fahrenheit. In at least one embodiment, the heat exchanger can be sized or otherwise arranged to provide a supply temperature of the secondary cooling fluid supplied to the load at any temperature from 50 degrees Fahrenheit to 115 degrees Fahrenheit.

In at least one embodiment, the primary cooling fluid can be a two-phase fluid, such as a refrigerant. In at least one embodiment, the primary cooling loop can include one or more compressors for circulating the primary cooling fluid through the primary cooling loop and/or compressing at least a portion of the primary cooling fluid, such as that portion vaporized in the heat exchanger, one or more condensers for condensing at least a portion of the primary cooling fluid and/or rejecting heat to an environment, or any combination thereof.

In at least one embodiment, the secondary cooling fluid can be a single-phase cooling fluid, such as a water-glycol mixture. In at least one embodiment, the secondary cooling loop can include one or more prime movers, such as a pump, for circulating the secondary cooling fluid through the secondary cooling loop, one or more loads for transferring heat to the secondary cooling fluid, one or more bypass valves plumbed in parallel with the heat exchanger for selectively permitting a bypass portion of the secondary cooling fluid to bypass the heat exchanger, or any combination thereof. In at least one embodiment, the bypass valve can be an electronically controlled valve. In at least one embodiment, the bypass portion of the secondary cooling fluid can flow from the load through the bypass valve, then through the prime mover, and then through the load. In at least one embodiment, a remaining portion of the secondary cooling fluid can flow from the load through the heat exchanger, then through the prime mover, and then through the load.

In at least one embodiment, a cooling system according to the disclosure can include one or more controllers for monitoring various aspects of the system and/or controlling various components of the system, such as the bypass valve. In at least one embodiment, the controller can monitor a suction pressure at the compressor, such as via a pressure transducer and/or other sensor. In at least one embodiment, the controller can control the suction pressure at the compressor using the bypass valve.

In at least one embodiment, the controller can control the bypass valve according to the suction pressure at the compressor, such as using a proportional-integral-derivative feedback control loop (or any component thereof) and/or a deadband (such as to limit movement of the bypass valve). In at least one embodiment, the controller can increase flow through the bypass valve as the suction pressure at the compressor increases and/or increase flow through the bypass valve when the suction pressure at the compressor increases a predetermined amount. In at least one embodiment, the controller can decrease flow through the bypass valve as the suction pressure at the compressor decreases and/or decrease flow through the bypass valve when the suction pressure at the compressor decreases a predetermined amount.

In at least one embodiment, the controller can monitor a supply temperature of the secondary cooling fluid supplied to the load. In at least one embodiment, the controller can control the supply temperature using the bypass valve. In at least one embodiment, the controller can control the supply temperature at any temperature from 50 degrees Fahrenheit to 115 degrees Fahrenheit. In at least one embodiment, the heat exchanger and/or other components of the system can be sized and/or otherwise arranged to provide a supply temperature of the secondary cooling fluid supplied to the load as low as 50 degrees Fahrenheit and the controller can control the supply temperature, such as using the bypass valve, to as high as 115 degrees Fahrenheit. In at least one embodiment, the controller can selectively increase a supply temperature of the secondary cooling fluid supplied to the load and/or otherwise control the suction pressure at the compressor by selectively extracting hot secondary cooling fluid upstream of the heat exchanger and/or injecting hot secondary cooling fluid between the heat exchanger and the load, such as downstream of the heat exchanger and upstream of the load.

Other and further embodiments utilizing one or more aspects of the disclosure can be devised without departing from the spirit of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope or range of equivalents of the following claims.
The disclosure comprises the following items:
1. A cooling system comprising:
   a primary cooling loop having a compressor configured to compress a primary cooling fluid;
   a heat exchanger configured to transfer heat to the primary cooling fluid from a secondary cooling fluid; and
   a secondary cooling loop having:
      a prime mover configured to circulate the secondary cooling fluid through a load; and
      a bypass valve plumbed in parallel with the heat exchanger and configured to selectively permit a bypass portion of the secondary cooling fluid to bypass the heat exchanger.
2. The cooling system as set forth in item 1, wherein the bypass valve is an electronically controlled valve; and further comprising a controller configured to control the bypass valve.
3. The cooling system as set forth in any preceding item, wherein the controller is further configured to monitor a suction pressure at the compressor.
4. The cooling system as set forth in any preceding item, wherein the controller is further configured to control the suction pressure at the compressor using the bypass valve.
5. The cooling system as set forth in any preceding item, wherein the controller is further configured to control the bypass valve according to the suction pressure at the compressor.
6. The cooling system as set forth in any preceding item, wherein the controller is further configured to increase flow through the bypass valve as the suction pressure at the compressor increases.
7. The cooling system as set forth in any preceding item, wherein the controller is further configured to increase flow through the bypass valve when the suction pressure at the compressor increases a predetermined amount.
8. The cooling system as set forth in any preceding item, wherein the controller is further configured to decrease flow through the bypass valve as the suction pressure at the compressor decreases.
9. The cooling system as set forth in any preceding item, wherein the controller is further configured to decrease flow through the bypass valve when the suction pressure at the compressor decreases a predetermined amount.
10. The cooling system as set forth in any preceding item, wherein the controller is further configured to control the bypass valve according to the suction pressure at the compressor using a proportional-integral-derivative feedback control loop.
11. The cooling system as set forth in any preceding item, wherein the controller is further configured to control the bypass valve according to the suction pressure at the compressor using a deadband to limit movement of the bypass valve.
12. The cooling system as set forth in any preceding item, wherein the bypass portion of the secondary cooling fluid is routed from the load through the bypass valve, then through the prime mover, and then through the load.
13. The cooling system as set forth in any preceding item, wherein a remaining portion of the secondary cooling fluid is routed from the load through the heat exchanger, then through the prime mover, and then through the load.
14. The cooling system as set forth in any preceding item, wherein the cooling system is further configured to control the suction pressure at the compressor by selectively extracting hot secondary cooling fluid upstream of the heat exchanger and injecting that hot secondary cooling fluid downstream of the heat exchanger and upstream of the load.
15. The cooling system as set forth in any preceding item, wherein the cooling system is further configured to selectively increase a supply temperature of the secondary cooling fluid supplied to the load by selectively extracting hot secondary cooling fluid upstream of the heat exchanger and injecting that hot secondary cooling fluid downstream of the heat exchanger and upstream of the load.
16. The cooling system as set forth in any preceding item, wherein the controller is further configured to monitor a supply temperature of the secondary cooling fluid supplied to the load.
17. The cooling system as set forth in any preceding item, wherein the controller is further configured to control the supply temperature using the bypass valve.
18. The cooling system as set forth in any preceding item, wherein the controller is further configured to control the supply temperature at any temperature from 50 degrees Fahrenheit to 115 degrees Fahrenheit.
19. The cooling system as set forth in any preceding item, wherein the primary cooling fluid is a two-phase fluid and the secondary cooling fluid is a single phase cooling fluid.
20. The cooling system as set forth in any preceding item, wherein the secondary cooling fluid is a water-glycol mixture.

## Claims

1. A cooling system comprising:
a primary cooling loop having a compressor configured to compress a primary cooling fluid;
a heat exchanger configured to transfer heat to the primary cooling fluid from a secondary cooling fluid; and
a secondary cooling loop having:
a prime mover configured to circulate the secondary cooling fluid through a load; and
a bypass valve plumbed in parallel with the heat exchanger and configured to selectively permit a bypass portion of the secondary cooling fluid to bypass the heat exchanger.

2. The cooling system as set forth in claim 1, wherein the bypass valve is an electronically controlled valve; and further comprising a controller configured to control the bypass valve.

3. The cooling system as set forth in claim 2, wherein the controller is further configured to monitor a suction pressure at the compressor, and optionally wherein the controller is further configured to control the suction pressure at the compressor using the bypass valve.

4. The cooling system as set forth in claim 3, wherein the controller is further configured to control the bypass valve according to the suction pressure at the compressor.

5. The cooling system as set forth in claim 3 or claim 4, wherein the controller is further configured to increase flow through the bypass valve as the suction pressure at the compressor increases, and/or wherein the controller is further configured to increase flow through the bypass valve when the suction pressure at the compressor increases a predetermined amount.

6. The cooling system as set forth in any of claims 3-5, wherein the controller is further configured to decrease flow through the bypass valve as the suction pressure at the compressor decreases, and/or wherein the controller is further configured to decrease flow through the bypass valve when the suction pressure at the compressor decreases a predetermined amount.

7. The cooling system as set forth in any of claims 3-6, wherein the controller is further configured to control the bypass valve according to the suction pressure at the compressor using a proportional-integral-derivative feedback control loop.

8. The cooling system as set forth in any of claims 3-7, wherein the controller is further configured to control the bypass valve according to the suction pressure at the compressor using a deadband to limit movement of the bypass valve.

9. The cooling system as set forth in any preceding claim, wherein the bypass portion of the secondary cooling fluid is routed from the load through the bypass valve, then through the prime mover, and then through the load.

10. The cooling system as set forth in any preceding claim, wherein a remaining portion of the secondary cooling fluid is routed from the load through the heat exchanger, then through the prime mover, and then through the load.

11. The cooling system as set forth in any of claims 3-10, wherein the cooling system is further configured to control the suction pressure at the compressor by selectively extracting hot secondary cooling fluid upstream of the heat exchanger and injecting that hot secondary cooling fluid downstream of the heat exchanger and upstream of the load.

12. The cooling system as set forth in any preceding claim, wherein the cooling system is further configured to selectively increase a supply temperature of the secondary cooling fluid supplied to the load by selectively extracting hot secondary cooling fluid upstream of the heat exchanger and injecting that hot secondary cooling fluid downstream of the heat exchanger and upstream of the load.

13. The cooling system as set forth in any of claims 2-12, wherein the controller is further configured to monitor a supply temperature of the secondary cooling fluid supplied to the load, and optionally wherein the controller is further configured to control the supply temperature using the bypass valve.

14. The cooling system as set forth in claim 12 or claim 13, wherein the controller is further configured to control the supply temperature at any temperature from 50 degrees Fahrenheit to 115 degrees Fahrenheit.

15. The cooling system as set forth in any preceding claim, wherein the primary cooling fluid is a two-phase fluid and the secondary cooling fluid is a single phase cooling fluid, and/or wherein the secondary cooling fluid is a water-glycol mixture.
